Europäisches Patentamt

European Patent Office

Office européen des brevets

(11) Numéro de publication : **0 298 002 B1**

# (12) FASCICULE DE BREVET EUROPEEN

(45) Date de publication du fascicule du brevet :
27.05.92 Bulletin 92/22

(51) Int. Cl.⁵ : **G06F 7/00**, G06F 15/347, G11C 19/28

(21) Numéro de dépôt : **88420230.0**

(22) Date de dépôt : **29.06.88**

(54) **Mémoire de transposition pour circuit de traitement de données.**

(30) Priorité : **03.07.87 FR 8709458**

(43) Date de publication de la demande :
**04.01.89 Bulletin 89/01**

(45) Mention de la délivrance du brevet :
**27.05.92 Bulletin 92/22**

(84) Etats contractants désignés :
**DE FR GB IT NL**

(56) Documents cités :
**US-A- 3 535 694**
**US-A- 4 302 775**

(73) Titulaire : **SGS-THOMSON**
**MICROELECTRONICS S.A.**
**7, Avenue Galliéni**
**F-94250 Gentilly (FR)**

(72) Inventeur : **Artieri, Alain**
**7, Allée des Eyminées**
**F-38240 Meylan (FR)**

(74) Mandataire : **de Beaumont, Michel et al**
**1bis, rue Champollion**
**F-38000 Grenoble (FR)**

Jouve, 18, rue Saint-Denis, 75001 PARIS

**Description**

L'invention concerne les circuits-intégrés de traitement de signaux numériques, et plus particulièrement ceux qui réalisent une double sommation pondérée, en ligne puis en colonne, de valeurs numériques x(i,j) d'une matrice de n x n valeurs numériques.

A partir des coefficients x(i,j) où i est un indice de ligne de la matrice, et j un indice de colonne, on cherche à produire une matrice de coefficients C(u,v) où u est un indice de ligne et v un indice de colonne, avec

$$C(u,v) = \sum_{i=0}^{i=n-1} C^i(v)\ g(i,u)$$

$$\text{avec } C^i(v) = \sum_{j=0}^{j=n-1} x(i,j)\ f(j,v)$$

A partir de signaux électriques d'entrée représentant les valeurs numériques x(i,j), on produit d'abord n x n signaux représentants des coefficients $C^i(v)$ ; chaque coefficient $C^i(v)$ représente une sommation pondérée des valeurs x(i,j) de la ligne i affectées de coefficients f(j,v) ; v représente un indice de colonne variant de O à n-1 et il y a n coefficients $C^i(v)$ pour chaque ligne d'indice i. Cette opération est appelée transformation ligne.

A partir des n x n signaux représentant les coefficients $C^i(v)$, on produit n x n signaux représentant les coefficients C(u,v) ; chaque coefficient C(u,v) est une sommation pondérée des valeurs $C^i(v)$ de la colonne v, affectées de coefficients g(i,u); u représente un indice de ligne variant de O à n-1 et on produit n coefficients C(u,v) pour chaque colonne d'indice v. Cette opération est la transformation colonne.

Ce type de traitement numérique se rencontre notamment pour réaliser des transformations dites transformations cosinus où les coefficients f(j, v) et g(i, u) sont de la forme cos (2i+1)u¶/2n ; ces transformations sont utiles pour faciliter la compression d'informations dans les transmissions numériques de signaux, et plus particulièrement pour la transmission numérique d'images.

Les architectures de circuits intégrés, telles que décrites par exemple dans le document US-A-4302775, permettant de réaliser ce type de transformation sont relativement complexes parce qu'elles doivent permettre un traitement en temps réel, c'est-à-dire que le débit de données numériques à traiter est imposé à l'entrée du circuit et le débit de données traitées à la sortie doit être aussi rapide que le débit à l'entrée. Bien entendu, ce débit est élevé et, à titre indicatif, pour la transmission numérique d'images, on veut pouvoir traiter un bloc de 16 x 16 valeurs numériques (256 points d'image) en moins de 20 microsecondes ; des blocs successifs de 256 valeurs se présentant à l'entrée du circuit avec une périodicité de l'ordre de 20 microsecondes.

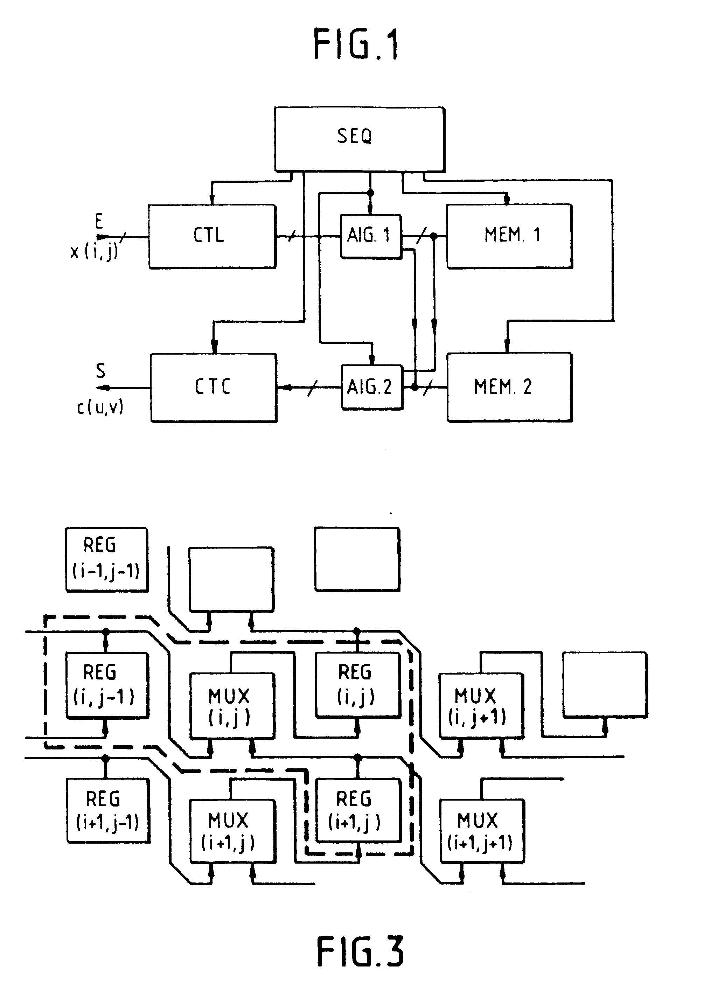

La figure 1 représente sous forme de schéma-bloc une architecture de circuit intégré assez simple que l'on peut imaginer pour réaliser sur une même puce de circuit intégré la transformation complète d'un bloc de n x n valeurs numériques x(i,j) en un bloc de n x n coefficients C(u,v).

Dans ce schéma, on utilise un premier opérateur CTL exécutant la sommation en ligne, un deuxième opérateur CTC exécutant la sommation en colonne, deux mémoires MEM 1 et MEM 2 pour le stockage de valeurs représentant les coefficients $C^i(v)$, et deux aiguillages AIG 1 et AIG 2 pour établir des chemins de connexion d'une part entre l'opérateur CTL et les mémoires MEM 1 et MEM 2 et d'autre part entre ces mémoires et l'opérateur CTC. L'ensemble est commandé par un séquenceur SEQ.

Un bloc de n x n données x(i,j) à traiter est amené, par un bus d'entrée E, à l'opérateur de transformée ligne CTL qui produit n x n données numériques représentant n x n coefficients numériques $C^i(v)$. Ces données sont stockées dans les n x n adresses de la mémoire MEM 1 (mémoire de n x n mots). Le rythme de traitement des blocs de n x n données est par exemple de un bloc traité par 20 microsecondes ; une donnée x(i,j) se présente par exemple toutes les 74 nanosecondes (pour n x n = 256).

Pour le traitement du bloc suivant de n x n valeurs x(i,j), le circuit CTL reçoit les valeurs successives x(i,j) et effectue la transformation ligne ; mais cette fois, le séquenceur SEQ commande l'aiguillage AIG1 de manière à stocker les résultats $C^i(v)$ dans la deuxième mémoire MEM 2. Pendant ce temps, les données précédemment enregistrées dans la mémoire MEM 1 sont appliquées à titre de valeurs numériques d'entrée à traiter, à travers l'aiguillage AIG2, au circuit de transformation colonne CTC qui produit à sa sortie les coefficients C(u,v).

2

Ainsi de suite, alternativement, un bloc de n x n coefficients $C^i(v)$ est stocké dans l'une des mémoires pendant qu'un bloc de coefficients $C^i(v)$ enregistré à la période précédente dans l'autre mémoire est traité.

Cette architecture est élégante mais nécessite deux mémoires capables de stocker chacune n x n données $C^i(v)$. Il faut bien comprendre en effet que pour pouvoir effectuer une transformation colonne sur les coefficients $C^i(v)$ tous les coefficients $C^i(v)$ d'une même colonne v doivent être mémorisées. Or, comme ces coefficients $C^i(v)$ arrivent du circuit CTL <u>ligne par ligne,</u> et non colonne par colonne, cela veut dire en pratique que la transformation colonne ne peut commencer que lorsque tous les coefficients $C^i(v)$ de la matrice sont arrivés du circuit CTL. C'est la raison pour laquelle l'architecture de la figure 1 utilise deux mémoires fonctionnant alternativement. De plus, il faut noter que si les données $C^i(v)$ sont inscrites dans une mémoire ligne par ligne (i étant l'indice de ligne), alors elles doivent être lues à la période suivante colonne par colonne (v étant l'indice de colonne).

De plus, si cette architecture est utilisée avec des opérateurs CTC et CTL traitant des données numériques dont les bits sont transmis en série (ou partiellement en série) et non pas exclusivement en parallèle, alors il faut prévoir en plus entre les opérateurs et les mémoires des convertisseurs série/parallèle et parallèle/série car les mémoires classiques, SRAM ou DRAM ne peuvent traiter que des données dont les bits sont amenés sous forme parallèle. Pourtant il est souvent intéressant, dès que les données ont plus de 4 bits, de prévoir des opérateurs CTC et CTL travaillant sur des bits série ou série-parallèle.

L'invention propose une nouvelle structure de mémoire de transposition permettant de recevoir des données groupées ligne par ligne et de les restituer groupées colonne par colonne; cette mémoire permet de remplacer les deux mémoires de la figure 1 et les aiguillages entre ces mémoires et les opérateurs CTC et CTL par un seul bloc mémoire. De plus, cette mémoire permet de ne pas utiliser de convertisseurs série/parallèle et parallèle/série dans le cas où les données sont traitées dans les opérateurs sous forme série ou série/parallèle.

La mémoire selon l'invention possède n entrées pour recevoir périodiquement n données groupées ligne par ligne et n sorties pour restituer selon la même périodicité les données groupées colonne par colonne, les données étant les n x n données d'une matrice carrée de données et les données étant transmises et traitées sous forme de signaux électriques. La mémoire comporte un réseau de registres et de multiplexeurs, agencés en lignes et colonnes, chaque registre étant associé à un multiplexeur. Le registre au carrefour d'une ligne i et d'une colonne j étant désigné par REG(i,j) et le multiplexeur correspondant par MUX(i,j), le multiplexeur MUX(i,j) ayant une première entrée reliée à la sortie du registre REG(i,j-1), une deuxième entrée reliée à la sortie du registre REG(i+1,j), et une sortie reliée à l'entrée du registre REG(i,j), la sortie du multiplexeur transmettant l'état de la première entrée pendant une première phase de fonctionnement de la mémoire au cours du période et transmettant l'état de la deuxième entrée pendant une deuxième phase au cours de la période suivante. Pour les premières et dernières lignes et colonnes du réseau, les connexions sont les suivantes:

a) les premières entrées des multiplexeurs de la première colonne (de rang 0) sont reliées chacune à une entrée respective de la mémoire;

b) les sorties des registres de la dernière colonne (de rang n-1) sont reliées chacune par un interrupteur respectif à une sortie respective de la mémoire, cet interrupteur étant fermé pendant la première phase et ouvert pendant la deuxième phase;

c) la sortie de chaque registre de la première ligne (de rang 0) est reliée, par un interrupteur ouvert pendant la première phase et fermé pendant la deuxième, à une sortie respective de la mémoire;

d) la deuxième entrée de chaque multiplexeur de la dernière ligne (de rang n-1) est reliée à une entrée respective de la mémoire.

Chaque registre est périodiquement rempli d'une nouvelle donnée et vidé de la donnée précédemment contenue; la période T correspond à la fréquence d'introduction de nouvelles lignes dans la mémoire. La première et la deuxième phases de fonctionnement de la mémoire, c'est-à-dire la première et la deuxième phases de fermeture et d'ouverture des interrupteurs et de basculement des multiplexeurs, durent chacune un temps nxT.

Ce type de mémoire est utilisable avec des registres stockant chacun en parallèle plusieurs bits d'une donnée, y compris avec des registres ayant chacun autant de cases de stockage en parallèle que de bits dans chaque donnée. Dans ce cas, la mémoire est utilisable directement entre deux opérateurs tels que CTL et CTC si ces opérateurs travaillent sur des données transmises sous forme de bits en parallèle.

Mais l'invention est particulièrement avantageuse dans le cas où les opérateurs travaillent sur des données transmises à la fois en série et en parallèle (par exemple, les données sont de 16 bits chacune, transmises sur deux fils en huit étapes successives) où encore des données transmises complètement en série sur un fil (par exemple des données de 16 bits transmises sur un fil en 16 étapes successives).

Dans ce cas, chaque registre est un registre à décalage à plusieurs positions successives entre son entrée et sa sortie; le nombre de positions successives entre l'entrée et la sortie est égal au nombre p de bits série des données à traiter; le registre est actionné avec une période t = T/p. Si les données se présentent plus généralement sous forme de m bits en parallèle et p bits en série (c'est-à-dire que chaque donnée est transmise sur m conducteurs en p étapes, le nombre de bits global de chaque donnée étant m x p), alors, chaque registre à décalage est constitué par m registres en parallèle recevant chacun les bits de l'un des m conducteurs, et les multiplexeurs comportent aussi chacun m premières entrées, m deuxièmes entrées et m sorties, chacune affectée à un conducteur particulier.

Le circuit de traitement de données de la figure 1 peut alors être remplacé par une architecture beaucoup plus simple dans laquelle l'opérateur CTC est relié à l'opérateur CTL par l'intermédiaire d'une seule mémoire de transposition selon l'invention, et ceci même si les opérateurs fonctionnent sur des données en série ou partiellement en série.

D'autres caractéristiques et avantages de l'invention apparaîtront à la lecture de la description détaillée qui suit et qui est faite en référence aux dessins annexés dans lesquels:

– la figure 1, déjà décrite représente une possibilité d'architecture de circuit exécutant une double sommation, en ligne puis en colonne, de valeurs numériques;

– la figure 2 représente symboliquement le réseau de registres constituant la mémoire selon l'invention, avec deux configurations différentes de connexions entre les registres et les entrées et sorties de la mémoire;

– la figure 3 représente un motif élémentaire du réseau de registres selon l'invention, avec les connexions entre registres voisins;

– la figure 4 représente les interconnexions entre les entrées et sorties de la mémoire et les premières et dernières lignes et colonnes du réseau de registres;

– la figure 5 représente un circuit de traitement de données utilisant une mémoire selon l'invention.

– la figure 6 représente un registre élémentaire de stockage d'un bit unique de données;

– la figure 7 représente le chronogramme des signaux de commande du registre élémentaire de la figure 6;

– la figure 8 représente le circuit d'établissement des signaux de commande du registre élémentaire de la figure 6;

– la figure 9 représente un registre REG(i,j) du réseau constituant la mémoire selon l'invention, ce registre étant constitué par m x p registres élémentaires de stockage d'un bit.

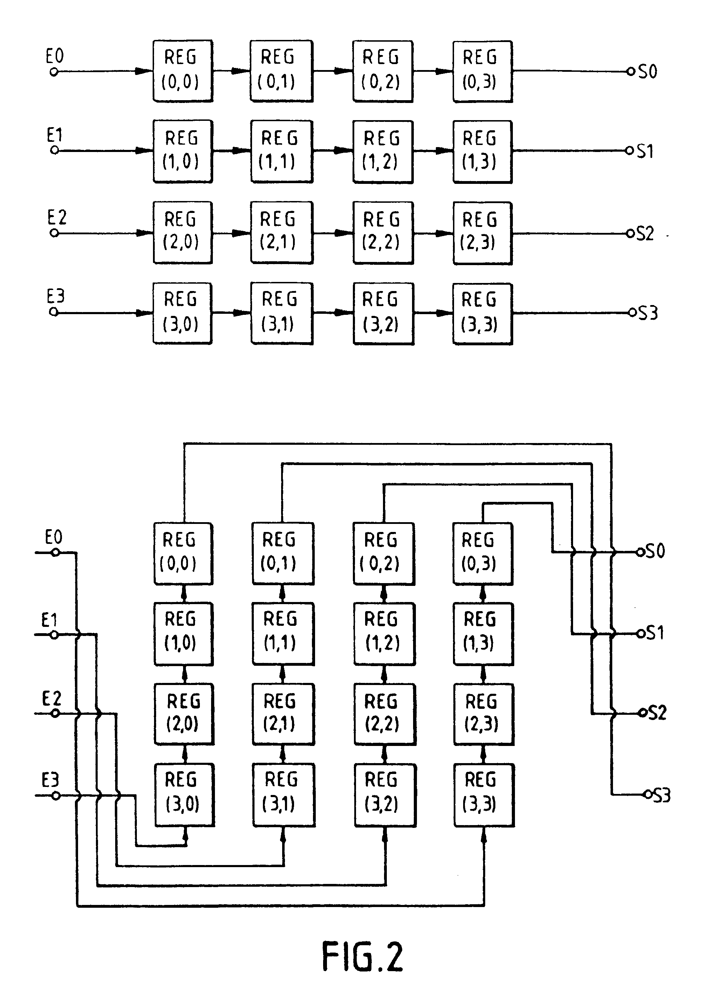

Pour mieux faire comprendre l'invention, on a représenté à la figure 2 un réseau simplifié de registres disposés en lignes et colonnes et destiné au stockage d'une matrice de n x n données numériques, avec n = 4. Le réseau est représenté dans deux configurations de connexions correspondant à deux phases de fonctionnement successives durant chacune un temps n x T où T est la période d'introduction des données successives dans le réseau. Les phases sont désignées dans ce qui suit par phase a et phase b respectivement.

Le haut de la figure 2 représente la première configuration, correspondant à la première phase (phase a). Le bas de la figure représente la deuxième configuration, correspondant à la deuxième phase (phase b).

Le réseau comporte n entrées, E0, E1, E2, E3 et n sorties S0, S1, S2, S3. Il comporte n x n registres susceptibles de stocker chacun une donnée numérique d'une matrice de données n x n qui serait constituée comme ci-après pour n = 4:

$$
\begin{array}{cccc}
C^0(0) & C^0(1) & C^0(2) & C^0(3) \\
C^1(0) & C^1(1) & C^1(2) & C^1(3) \\
C^2(0) & C^2(1) & C^2(2) & C^2(3) \\
C^3(0) & C^3(1) & C^3(2) & C^3(3)
\end{array}
$$

Les registres sont désignés par les références REG(i,j) où i est le numéro de la ligne et j le numéro de la colonne dans lequel se situe le registre; ainsi, la première ligne comprend les registres REG(0,0), REG(0,1), REG(0,2), REG(0,3), la deuxième ligne les registres REG(1,0), REG(1,1), etc.

Dans la première phase a de fonctionnement, les entrées E0 à E3 du réseau sont reliées aux entrées des différents registres de la première colonne, et les sorties du réseau, S0 à S3, sont reliées aux sorties des registres de la dernière colonne. De plus, l'entrée de chaque registre des colonnes autres que la première est reliée à la sortie du registre de la colonne précédente sur la même ligne.

Les données du bloc matriciel ci-dessus sont amenées successivement ligne par ligne sur les entrées E0 à E3, c'est-à-dire que pendant une première période T, les entrées reçoivent les quatre données de la première ligne, puis, à la période suivante celles de la deuxième ligne, etc.

4

Le réseau contient toutes les données au bout d'un temps égal à n x T, et ces données se présentent alors selon la configuration ci-dessous à l'intérieur du réseau de registres:

$$C^3(0) \qquad C^2(0) \qquad C^1(0) \qquad C^0(0)$$
$$C^3(1) \qquad C^2(1) \qquad C^1(1) \qquad C^0(1)$$
$$C^3(2) \qquad C^2(2) \qquad C^1(2) \qquad C^0(2)$$
$$C^3(3) \qquad C^2(3) \qquad C^1(3) \qquad C^0(3)$$

Dans une deuxième phase b de fonctionnement, durant aussi un temps n x T, la configuration d'interconnexions à l'intérieur du réseau de registres change et devient celle qui est représentée au bas de la figure 2. Les entrées E0, E1, E2, E3 sont connectées aux entrées des registres de la dernière ligne, et les sorties S0, S1, S2, S3 sont connectées aux sorties des registres de la première ligne . De plus, l'entrée de chaque registre des lignes autres que la dernière est reliée à la sortie du registre de la ligne suivante dans la même colonne.

Par conséquent, pendant cette deuxième phase de n périodes T, le réseau de registres va d'une part se charger de nouvelles données (un autre bloc matriciel de n x n données), et d'autre part se décharger des données précédemment stockées.

Mais le déchargement s'effectue à travers les registres de la première ligne et les données remontent progressivement des autres lignes vers la première ligne, de sorte que les données qui sortent sont d'abord les données suivantes:

$$C^3(0) \qquad C^2(0) \qquad C^1(0) \qquad C^0(0)$$

puis les données suivantes:

$$C^3(1) \qquad C^2(1) \qquad C^1(1) \qquad C^0(1)$$

etc.

Autrement dit, alors qu'on avait introduit les données du bloc matriciel ligne par ligne pendant la première phase, on les ressort colonne par colonne.

De même, pendant cette deuxième phase, on introduit à nouveau des données ligne par ligne comme précédemment, mais elles arrivent par la dernière ligne du réseau de registres et remontent progressivement "verticalement" d'une ligne à la précédente (alors que dans la première phase elles se déplaçaient "horizontalement" d'une colonne à la suivante).

Il en résulte qu'à la fin de la deuxième phase, la configuration des données dans le réseau de registres est la suivante:

$$C'^0(3) \qquad C'^0(2) \qquad C'^0(1) \qquad C'^0(0)$$
$$C'^1(3) \qquad C'^1(2) \qquad C'^1(1) \qquad C'^1(0)$$
$$C'^2(3) \qquad C'^2(2) \qquad C'^2(1) \qquad C'^2(0)$$
$$C'^3(3) \qquad C'^3(2) \qquad C'^3(1) \qquad C'^3(0)$$

L'indice "prime" indique qu'il s'agit d'un nouveau bloc de données.

On recommence alors une première phase a, c'est-à-dire qu'on repasse dans la configuration de connexions du haut de la figure 2 et on sort les données horizontalement; les premières données qui sortent sont donc les suivantes:

$$C'^0(0) \qquad C'^1(0) \qquad C'^2(0) \qquad C'^3(0)$$

puis

$$C'^0(1) \qquad C'^1(1) \qquad C'^2(1) \qquad C'^3(1)$$

Autrement dit, là encore, les données qui ont été introduites ligne par ligne lors de la deuxième phase sont restituées colonne par colonne lors d'une nouvelle première phase.

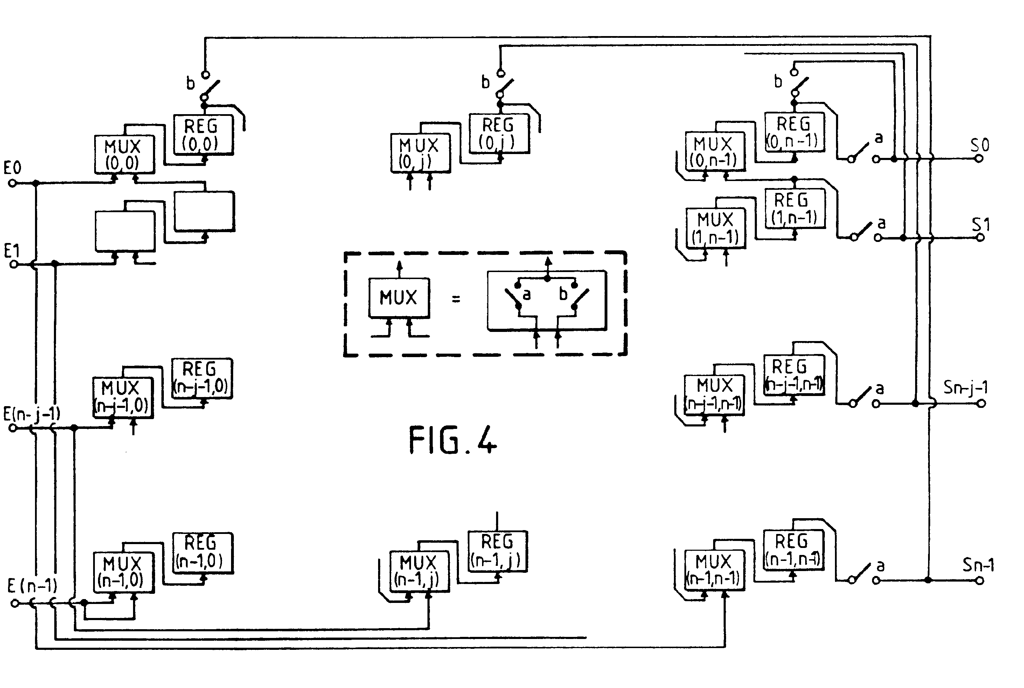

Alors que la figure 2 n'est qu'un schéma symbolique de connexions des registres dans les deux configurations alternées du réseau, la figure 3 montre la constitution précise du réseau qui permet d'aboutir au fonctionnement décrit ci-dessus.

On a représenté sur la figure 3 quelques cellules adjacentes du réseau de registres pour montrer leurs interconnexions. Le motif élémentaire qui se reproduit dans tout le réseau, est entouré d'un trait tireté.

A chaque registre REG(i,j) correspondant à la $i^{ème}$ ligne et a la $j^{ème}$ colonne, est associé un multiplexeur MUX(i,j).

L'indice de ligne i varie de 0 à n-1 et l'indice de colonne j varie de 0 à n-1 également.

Chaque registre comporte une entrée et une sortie et il stocke régulièrement, avec une période T, une nouvelle donnée qui se présente sur son entrée.

Chaque multiplexeur comporte une première et une deuxième entrée, et une sortie. Il fournit sur sa sortie le signal présent sur sa première entrée pendant la première phase (phase a), et au contraire le signal présent sur sa deuxième entrée pendant la deuxième phase (phase b). Il est donc commandé par un signal logique de période 2 n x T représentant les deux phases de fonctionnement de la mémoire.

On donnera plus loin des exemples de réalisation de registres et multiplexeurs, mais on peut déjà dire que leur constitution dépend du type de données qui sont reçues:

a) si les données sont fournies sous forme de m bits en parallèle, les entrées et sorties des registres et des multiplexeurs sont des bus de m conducteurs; les registres possèdent chacun m cases en parallèle.

b) si les données sont fournies sous forme de p bits en série, les entrées et sorties comportent à chaque fois un seul conducteur transmettant ces bits à un rythme régulier de période t = T/p; le registre est un registre à décalage à p positions successives, actionné à la période t = T/p, et chaque bit de donnée introduit à l'entrée d'un registre se retrouve à la sortie au bout du temps T.

c) si les données sont traitées d'une manière mixte, série/parallèle, la structure est mixte: si les données comportent p bits en série sur chacun de m conducteurs, les entrées et sorties des registres et multiplexeurs sont des bus de m conducteurs, et les registres sont des ensembles de m registres à décalage travaillant en parallèle, chaque registre à décalage ayant p positions successives et étant actionné à la période t = T/p.

L'invention s'avère particulièrement intéressante dans les cas b) et c).

Pour revenir à la figure 3, on voit que le motif de connexions qui se répète sur tout le réseau est le suivant: la première entrée du multiplexeur MUX(i,j) de la ligne i et de la colonne j est reliée à la sortie du registre REG(i,j-1), c'est-à-dire le registre de rang de colonne immédiatement inférieur sur la même ligne i; la deuxième entrée du multiplexeur est reliée à la sortie du registre REG(i+1,j), c'est-à-dire le registre de rang de ligne suivant de la même colonne j.

La sortie du multiplexeur est reliée à l'entrée du registre REG(i,j).

Ce motif d'interconnexion se répète sur tout le réseau à l'exception évidemment des extrémités du réseau, c'est-à-dire des premières et dernières lignes et colonnes.

La figure 4 représente les connexions entre ces premières et dernières lignes et colonnes et les entrées et sorties du réseau.

Ces connexions se font par l'intermédiaire d'interrupteurs actionnés avec la même périodicité n x T que les multiplexeurs de manière que le réseau passe effectivement de la configuration du haut de la figure 2 à la configuration du bas de la figure 2 avec cette même période.

Les connexions sont les suivantes:

Les multiplexeurs de la première colonne (de rang 0 en colonne) ont tous leur première entrée reliée directement à une entrée respective de la mémoire: la première entrée du multiplexeur MUX(0,0) est reliée à l'entrée E0, celle du multiplexeur MUX(1,0) à l'entrée E1, celle du multiplexeur MUX(n-j-1,0) à l'entrée E(n-j-1), etc.

La sortie de chaque registre de la première ligne (de rang 0 en ligne) est reliée par un interrupteur respectif, ouvert pendant la première phase a et fermé pendant la deuxième phase b, à une sortie respective de la mémoire: la sortie du registre REG(0,0) est reliée par un interrupteur à la sortie S(n-1); celle du registre REG(0,j) est reliée à la sortie S(n-j-1); celle du registre REG(0,n-1) à la sortie S0.

La sortie de chaque registre de la dernière colonne (de rang n-1 en colonne) est reliée par un interrupteur respectif, fermé pendant la première phase a et ouvert pendant la deuxième phase b, à une sortie de la mémoire: la sortie du registre REG(0,n-1) est ainsi reliée à la sortie S0, celle du registre REG(1,n-1) à la sortie S1, etc.

Enfin, la deuxième entrée de chaque multiplexeur de la dernière ligne (de rang n-1 en ligne) est reliée à une entrée respective de la mémoire: la deuxième entrée du multiplexeur MUX(n-1,0) est reliée à l'entrée E(n-1), celle du multiplexeur MUX(n-1,j) est reliée à l'entrée E(n-j-1), celle du multiplexeur MUX(n-1,n-1) est reliée à l'entrée E0. On rappelle que la deuxième entrée du multiplexeur est celle qui est reliée à sa sortie pendant la phase b tandis que la première entrée est reliée à sa sortie pendant la phase a.

Le circuit ainsi décrit en référence aux figures 3 et 4 constitue une mémoire unique de n x n données dans laquelle un bloc de n x n données est introduit ligne par ligne et dans laquelle les données sont restituées colonne par colonne en même temps qu'un nouveau bloc de données est introduit ligne par ligne.

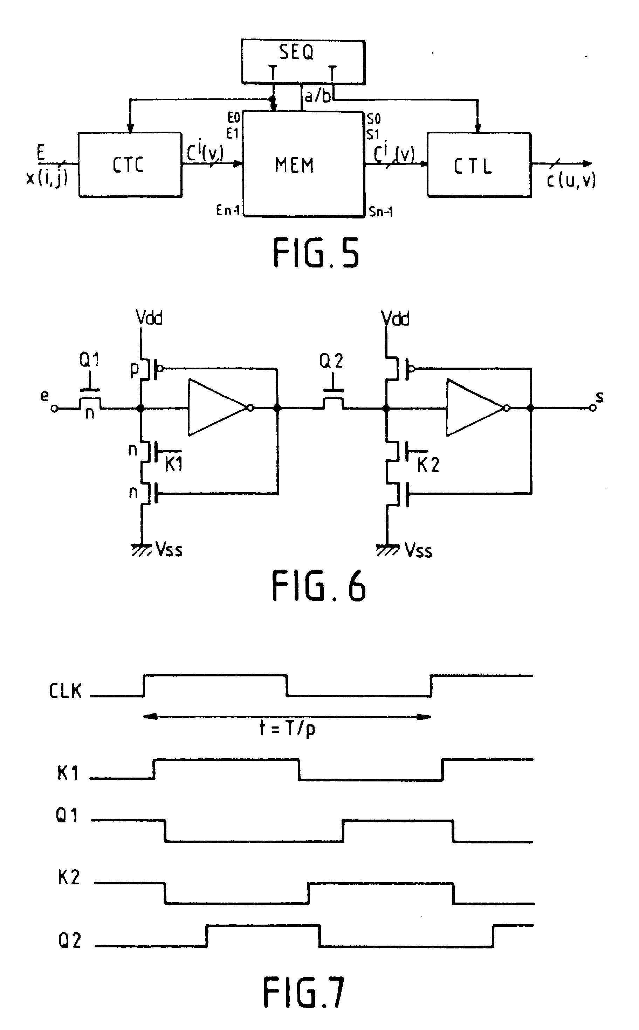

On peut donc réaliser l'architecture de circuit de traitement de données numériques de la figure 5, qui est beaucoup plus simple que l'architecture à deux mémoires de la figure 1, et qui est extrêmement avantageuse dans le cas où les opérateurs CTC et CTL traitent des données de type série.

On va maintenant décrire, en référence aux figures suivantes, une réalisation pratique de cette mémoire pour le cas général où les données arrivent sous forme série/parallèle; on supposera que les données arrivent en p bits série sur un bus de m conducteurs.

Le registre de base qui peut être utilisé pour stocker un bit de donnée est représenté à la figure 6.

Il comprend deux étages identiques en cascade et il est commandé par quatre signaux d'horloge de période t = T/p; ces signaux sont représentés à la figure 7; ils sont produits à partir d'une horloge CLK de période T/p; les signaux K1 et Q1 commandent le premier étage du registre; les signaux K2 et Q2 commandent le deuxième étage.

K1 est sensiblement identique au signal CLK; K2 est obtenu simplement par inversion de CLK; Q1 est un signal ayant une transition vers le niveau logique bas après la transition de K1 vers le niveau logique haut et ayant une transition vers le niveau haut retardée par rapport à la transition vers le bas de Q2; Q2 a, vis-à-vis de K2 et Q1, la même relation que Q1 vis-à-vis de K1 et Q2.

Chaque étage du registre élémentaire de la figure 6 est constitué comme on le voit sur la figure d'un premier transistor a canal N en série entre l'entrée de l'étage et l'entrée d'un inverseur; ce transistor est commandé par le signal Q1 (Q2 pour le deuxième étage); la sortie de l'inverseur est rebouclée d'une part sur la grille d'un transistor à canal P inséré entre une source de tension Vdd et l'entrée de l'inverseur; d'autre part sur la grille d'un transistor à canal N; ce dernier est en série entre une borne de masse Vss et un autre transistor à canal N relié par ailleurs à l'entrée de l'inverseur et commandé par le signal K1 (ou K2 pour le deuxième étage).

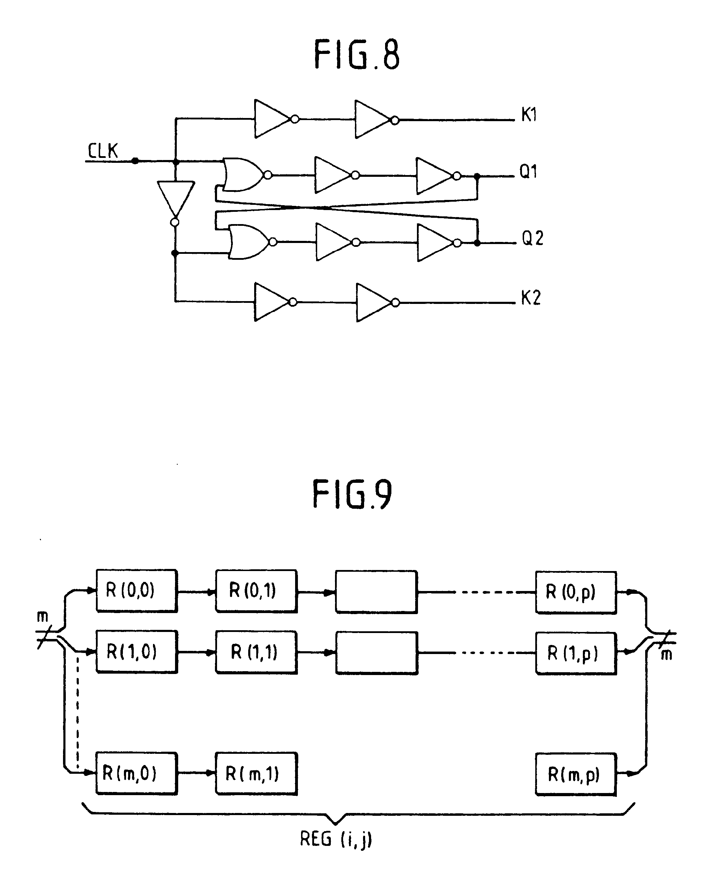

La figure 8 montre un circuit avec neuf inverseurs et deux portes NOR permettant de générer les signaux K1, Q1, K2, Q2 à partir d'un signal d'horloge CLK symétrique de période T/p.

La figure 9 montre comment on réalise un registre REG(i,j) à partir de m x p registres élémentaires lorsque les données comprennent p bits en série sur un bus de m conducteurs en parallèle; chaque rectangle sur la figure 9 représente un registre élémentaire de stockage d'un bit, c'est-à-dire qu'un rectangle correspond au circuit à deux étages de la figure 6.

L'entrée du registre REG(i,j) se fait par un bus de m conducteurs, chaque conducteur arrivant à l'entrée d'un ensemble respectif de p registres élémentaires en cascade; il y a m ensembles en parallèle correspondant chacun à un conducteur du bus d'entrée; la sortie du dernier registre de chaque ensemble en cascade constitue un conducteur de sortie du registre REG(i,j); la sortie globale du registre REG(i,j) est un bus de m conducteurs constitué par les conducteurs de sortie des m ensembles en parallèle.

Tous les registres élémentaires du registre REG(i,j) ainsi d'ailleurs que des autres registres de la mémoire sont commandés par les mêmes signaux K1,Q1,K2,Q2.

Les multiplexeurs comportent dans ce cas une première entrée constituée par un bus de m conducteurs, une deuxième entrée constituée par un bus de m conducteurs, et une sortie constituée par un bus de m conducteurs, le bus de sortie étant relié au bus de la première entrée pendant la phase a et au bus de la deuxième entrée pendant la phase b.

## Revendications

1. Mémoire de transposition comportant n entrées (EO à En-1) pour recevoir périodiquement n x n données groupées ligne par ligne, et n sorties (SO à Sn-1) pour restituer selon la même périodicité les données groupées colonne par colonne, les données étant les n x n données d'une matrice carrée de données et les données étant transmises et traitées sous forme de signaux électriques, caractérisée en ce qu'elle comprend un réseau de n x n registres (REG(i,j)) et de n x n multiplexeurs (MUX(i,j)), agencés en n lignes et n colonnes, chaque registre étant associé à un multiplexeur et étant repéré par sa position en ligne i et sa position en colonne j, le multiplexeur MUX(i,j) ayant une première entrée reliée à la sortie du registre REG(i,j-1), une deuxième entrée reliée à la sortie du registre REG(i+1,j), et une sortie reliée à l'entrée du registre REG(i,j), la sortie du multiplexeur transmettant l'état de la première entrée pendant une première phase (a) de fonctionnement de la mémoire au cours d'une période et transmettant l'état de la deuxième entrée pendant la deuxième phase (b) au cours de la période suivante, et les connexions des registres et multiplexeurs des premières et dernières lignes et colonnes du réseau étant les suivantes :

a) les premières entrées des multiplexeurs de la première colonne (de rang 0) sont reliées chacune à une entrée respective de la mémoire ;

b) les sorties des registres de la dernière colonne (de rang n-1) sont reliées chacune par un interrupteur respectif à une sortie respective de la mémoire, cet interrupteur étant fermé pendant la première phase et ouvert pendant la deuxième phase ;

c) la sortie de chaque registre de la première ligne (de rang 0) est reliée, par un interrupteur ouvert pendant la première phase et fermé pendant la deuxième, à une sortie respective de la mémoire ;

d) la deuxième entrée de chaque multiplexeur de la dernière ligne (de rang n-1) est reliée à une entrée respective de la mémoire.

2. Mémoire selon la revendication 1, caractérisée en ce que chaque registre est périodiquement rempli d'une nouvelle donnée et vidé de la donnée précédemment contenue avec une période T correspondant à la fréquence d'introduction de nouvelles lignes dans la mémoire, et en ce que la première et la deuxième phases de fonctionnement de la mémoire durent chacune un temps n x T.

3. Mémoire selon l'une des revendications 1 et 2, caractérisée en ce que chaque registre est constitué par m ensembles en parallèle de p registres élémentaires en cascade dans chaque ensemble, chaque registre élémentaire étant capable de stocker un bit de donnée et étant actionné périodiquement pour recevoir et transmettre une nouveau bit, la période étant une période T/p où T est la période d'introduction de nouvelles données dans la mémoire, l'entrée du registre REG(i,j) étant constituée par un bus de m conducteurs et sa sortie par un autre bus de m conducteurs, les entrées et les sorties des multiplexeurs étant également constituées par des bus de m conducteurs.

4. Circuit de traitement de données numériques pour exécuter, sur un bloc de n x n données transmises sous forme de signaux électriques, une sommation de données en ligne suivie d'une sommation en colonne sur le résultat de la sommation en ligne, caractérisé en ce qu'il comporte un premier opérateur (CTL) pour la sommation en ligne, recevant les données à traiter, les sorties du premier opérateur étant reliées aux entrées d'une mémoire selon l'une des revendications 1 à 3, et les sorties de la mémoire étant reliées aux entrées d'un deuxième opérateur (CTC) pour la sommation en colonne.

## Patentansprüche

1. Austauschspeicher mit n Eingängen (E0 bis En-1) zum periodischen Empfangen von n x n gruppierten Daten zeilenweise und n Ausgängen (S0 bis Sn-1) zum Ausgeben der gruppierten Daten gemäß derselben Periodizität spaltenweise, wobei die Daten die n x n Daten einer quadratischen Datenmatrix sind und in Form von elektrischen Signalen übertragen und verarbeitet werden, dadurch **gekennzeichnet**, daß der Austauschspeicher ein Netzwerk aus n x n Registern (REG(i,j)) und n x n Multiplexern (MUX(i,j)) aufweist, die in n Zeilen und n Spalten angeordnet sind, jedes Register mit einem Multiplexer verbunden und durch seine Position in Zeile i und Spalte j festgelegt ist, der Multiplexer MUX(i,j) einen ersten mit dem Ausgang des Registers REG(i,j-1) verbundenen Eingang, einen zweiten mit dem Ausgang des Registers REG(i+1,j) verbundenen Eingang und einen mit dem Eingang des Registers REG (i,j) verbundenen Ausgang aufweist, wobei der Multiplexer-Ausgang den Zustand des ersten Eingangs während einer ersten Betriebsphase (a) des Speichers während einer Periode überträgt und den Zustand des zweiten Eingangs während einer zweiten Phase (b) während der folgenden Periode überträgt, und die Verbindungen der Register und Multiplexer der ersten und letzten Zeilen und Spalten des Netzwerkes wie folgt sind:

a) die ersten Eingänge der Multiplexer der ersten Spalte (Rang 0) sind jeweils mit einem entsprechenden Eingang des Speichers verbunden,

b) die Ausgänge der Register der letzten Spalte (Rang n-1) sind jeweils über einen entsprechenden Schalter mit einem entsprechenden Ausgang des Speichers verbunden, wobei dieser Schalter während der ersten Phase geschlossen und während der zweiten Phase geöffnet ist,

c) der Ausgang jedes Registers der ersten Zeile (Rang 0) ist über einen während der ersten Phase geöffneten und während der zweiten Phase geschlossenen Schalter mit einem entsprechenden Ausgang des Speichers verbunden,

d) der zweite Eingang jedes Multiplexers der letzten Zeile (Rang n-1) ist mit einem entsprechenden Eingang des Speichers verbunden.

2. Speicher nach Anspruch 1, dadurch **gekennzeichnet**, daß jedes Register periodisch mit einer der Eintrittsfrequenz der neuen Zeilen in den Speicher entsprechenden Periode T mit einem neuen Datum gefüllt wird und das zuvor enthaltene Datum abgeworfen wird, und daß die erste und die zweite Betriebsphasen des Speichers jeweils eine Zeitspanne n x T dauern.

3. Speicher nach Anspruch 1 oder 2, dadurch **gekennzeichnet,** daß jedes Register aus n parallelen Sätzen von p Elementarregistern in Kaskade in jedem Satz besteht, wobei jedes Elementarregister ein Daten- bit speichern kann und periodisch zum Empfangen und Senden eines neuen Bits in Betrieb gesetzt wird, die Periode, welche eine Periode T/p oder T ist, gleich der Eingabeperiode neuer Daten in den Speicher ist, der Eingang des Registers REG(i,j) durch einen Bus aus m Leitern und sein Ausgang durch einen weiteren Bus aus m Leitern gebildet wird und die Eingänge und die Ausgänge des Multiplexers ebenfalls durch Busse aus m Leitern gebildet werden.

4. Digitaler Datenverarbeitungs-Schaltkreis zum Ausführen, mit einem Block aus n x n in Form elektrischer Signale übertragenen Daten, einer Zeilensummenbildung der Daten gefolgt von einer Spaltensummenbildung des dem Ergebnisses der Zeilensummenbildung, dadurch **gekennzeichnet**, daß der Schaltkreis einen ersten Operator (CTL) für die Zeilensummenbildung aufweist, der die zu verarbeitenden Daten empfängt, wobei die Ausgänge des ersten Operators mit Eingängen eines Speichers nach einem der Ansprüche 1 bis 3 verbunden sind und die Ausgänge des Speichers mit Eingängen eines zweiten Operators (CTC) für die Spaltensummenbildung verbunden sind.

## Claims

1. A transposition memory comprising n inputs (E0 to En-1) for periodically receiving n x n data groups line after line, and n outputs (S0 to Sn-1) for outputting with the same periodicity the data grouped according to successive columns, the data being the n x n data of a data square matrix, the data being further transmitted and processed in the form of electrical signals, characterized in that it comprises a network of n x n registers (REG(i,j)) and of n x n multiplexers (MUX(i,j)), arranged in n lines and n columns, each register being associated with one multiplexer and being marked by its location in line i and its location in column j, the multiplexer (MUX(i,j)) having a first input connected with the output of register REG(i,j-1), a second input connected with the output of register REG(i+1,j) and an output connected with the input of register (REG(i,j)), the multiplexer output transmitting the status of the first input during a first operating phase (a) of the memory during a period and further transmitting the status of the second input during a second phase (b) during the next period, and the connections of the registers and multiplexers of the first and last lines and columns of the network being as follows:

a) the first inputs of the multiplexers of the first column (rank 0) are each connected with a respective input of the memory;

b) the outputs of the registers of the last column (rank n-1) are each connected through a respective switch with a respective output of the memory, said switch being closed during the first phase and open during the second phase;

c) the output of each register of the first line (rank 0) is connected, through a switch open during the first phase and closed during the second phase, with a respective output of the memory;

d) the second input of each multiplexer of the last line (rank n-1) is connected with a respective input of the memory.

2. A memory according to claim 1, characterized in that each register is periodically filled with a new datum and cleared of the previously recorded data within a time period T corresponding to the introduction frequency of new lines into the memory, and the first and second operating phases of the memory each last a time period n x T.

3. A memory according to claim 1 or 2, characterized in that each register is constituted of m parallel sets of p elementary registers in cascade, each elementary register being capable of storing one data bit and being periodically operated in order to receive and transmit a new bit, the period being a period T/p wherein T is the introduction time period of new data into the memory, the input of register REG(i,j) being constituted by a bus of m conductors and its output being constituted by another bus of m conductors, the multiplexer inputs and outputs being also constituted by buses of m conductors.

4. A digital data processing circuit for carrying out, on one block of n x n data transmitted in the form of electrical signals, a data line summation followed with a data column summation of the result of the line summation, characterized in that it comprises a first operator (CTL) for the line summation, receiving the data to be processed, the outputs of the first operator being connected with the inputs of a memory, according to any of claims 1 to 3, and the outputs of the memory being connected with the inputs of a second operator (CTC) for the column summation.

# FIG.1

```
                    ┌──────────────────┐
                    │       SEQ        │
                    └──────────────────┘

E
x(i,j)   ┌───────────┐    ┌────────┐   ┌──────────────┐
─────────│    CTL    │────│ AIG. 1 │───│    MEM. 1    │
         └───────────┘    └────────┘   └──────────────┘

S        ┌───────────┐    ┌────────┐   ┌──────────────┐
─────────│    CTC     │───│ AIG.2  │───│    MEM. 2    │
c(u,v)   └───────────┘    └────────┘   └──────────────┘
```

```
┌──────────┐        ┌──────────┐    ┌──────────┐
│   REG    │        │          │    │          │
│ (i−1,j−1)│        │          │    │          │
└──────────┘        └──────────┘    └──────────┘

┌──────────┐  ┌──────────┐  ┌──────────┐  ┌──────────┐  ┌──────────┐
│   REG    │  │   MUX    │  │   REG    │  │   MUX    │  │          │
│ (i,j−1)  │  │  (i,j)   │  │  (i,j)   │  │ (i,j+1)  │  │          │
└──────────┘  └──────────┘  └──────────┘  └──────────┘  └──────────┘

┌──────────┐  ┌──────────┐  ┌──────────┐  ┌──────────┐
│   REG    │  │   MUX    │  │   REG    │  │   MUX    │
│ (i+1,j−1)│  │ (i+1,j)  │  │ (i+1,j)  │  │ (i+1,j+1)│
└──────────┘  └──────────┘  └──────────┘  └──────────┘
```

# FIG.3

FIG.2

FIG.4

EP 0 298 002 B1

MUX (0,0)  REG (0,0)  b

MUX (0,j)  REG (0,j)  b

MUX (0,n-1)  REG (0,n-1)  b  a  S0

MUX (1,n-1)  REG (1,n-1)  a  S1

MUX = a b

MUX (n-j-1,0)  REG (n-j-1,0)

MUX (n-j-1,n-1)  REG (n-j-1,n-1)  a  Sn-j-1

MUX (n-1,0)  REG (n-1,0)

MUX (n-1,j)  REG (n-1,j)

MUX (n-1,n-1)  REG (n-1,n-1)  a  Sn-1

E0

E1

E(n-j-1)

E(n-1)

FIG. 5

FIG. 6

FIG.7

# FIG.8

# FIG.9

REG (i, j)